# EUROPÄISCHE PATENTSCHRIFT

(11) **EP 0 606 283 B1**
(45) Veröffentlichungstag und Bekanntmachung des Hinweises auf die Patenterteilung: **05.07.1995**
(21) Anmeldenummer: 92919969.3
(22) Anmeldetag: 24.09.1992
(51) Int. Cl.: G01R 31/34

(54) **VERFAHREN UND ZUGEHÖRIGE MESSANORDNUNG ZUR BEWERTUNG DES LICHTBOGENS AN GLEITKONTAKTEN VON ELEKTRISCHEN MASCHINEN**
PROCESS AND APPROPRIATE MEASURING ARRANGEMENT FOR ASSESSING THE ARC ON SLIDING CONTACTS OF ELECTRIC MACHINES
PROCEDE ET DISPOSITIF DE MESURE CORRESPONDANT POUR L'EVALUATION DE L'ARC ELECTRIQUE SUR LES CONTACTS GLISSANTS DE MACHINES ELECTRIQUES

(30) Priorität: 30.09.1991 DE 4132533
(43) Veröffentlichungstag der Anmeldung: 20.07.1994
(73) Patentinhaber: SIEMENS AKTIENGESELLSCHAFT, 80333 München (DE)
(72) Erfinder: LINDE, Mathias, D-8500 Nürnberg 90 (DE)
(86) Internationale Anmeldenummer: DE9200823
(87) Internationale Veröffentlichungsnummer: WO9307503

(56) Entgegenhaltungen:
- DE-A- 3 603 740
- US-A- 4 356 443
- US-A- 4 446 426
- NTIS TECH NOTES Juli 1988, SPRINGFIELD, VA US Seiten 567-1 - 567-2 OAK RIDGE
- NATIONAL LAB 'MOTOR CURRENT SIGNATURE ANALYSIS PROCESS'
- PATENT ABSTRACTS OF JAPAN vol. 4, no. 103 (P-20)23. Juli 1980
- IEEE TRANSACTIONS ON POWER APPARATUS AND SYSTEMS Bd. 102, Nr. 4, April 1983, NEW YORK US Seiten 928 - 933 MICHIGUCHI ET AL. 'DEVELOPMENT OF A COLLECTOR RING MONITOR...'

## Beschreibung

Die Erfindung bezieht sich auf ein Verfahren zur Bewertung des Lichtbogens an Gleitkontakten von elektrischen Maschinen, insbesondere des Bürstenfeuers bei Motoren oder dergleichen, bei dem ein Ersatzkriterium für den Lichtbogen, insbesondere das Bürstenfeuer, an den Anschlußklemmen der elektrischen Maschine erfaßt und hinsichtlich vorgegebener Kenngrößen ausgewertet wird. Daneben bezieht sich die Erfindung auf eine zugehörige Meßanordnung zur Lichtbogen-, insbesondere Bürstenfeuerbewertung, wobei die Anschlußklemmen der elektrischen Maschine über Ausgangsleitungen mit Einheiten zur elektrischen Versorgung und/oder Steuerung verbunden sind und wobei ein HF-Stromwandler und ein zugehöriges Auswertegerät vorhanden sind.

Insbesondere bei Motoren mit Kommutator treten an den Kommutatorkontakten Lichtbögen auf, die unabhängig von der speziellen Ausbildung der Kontakte wie als Bürsten, Schleifringen, Gleitkontakte oder dergleichen im allgemeinen als sogenanntes Bürstenfeuer bezeichnet werden. Ein solches Bürstenfeuer kann bis zu einem gewissen Maße toleriert werden. Zu starkes Bürstenfeuer ist jedoch ein Kriterium für Fehler bzw. Schwachstellen im Motor, so daß das Bürstenfeuer selbst im Rahmen der Fertigungsüberwachung als Qualitätskriterium herangezogen werden kann.

Aus der DE-B1 36 03 740 ist bereits eine Einrichtung zur Überwachung des Zustandes von elektrischen Maschinen mit Bürsten, Schleifringen, Gleitkontakten etc. bekannt, bei der in Leitungen der elektrischen Maschine mindestens eine Primärspule eines Hochfrequenzübertragers geschaltet ist, die in eine Sekundärspule eine Spannung oder einen Strom induziert, deren/dessen Größe eine Spannungsmeßeinrichtung zur Erfassung des Zustandes der Maschine auswertet. Eine derartige Schaltung ist ziemlich komplex aufgebaut und insbesondere nur für vergleichsweise kleine elektrische Maschinen anwendbar. Für mittlere und größere elektrische Maschinen, insbesondere für Motoren mit hohen Strömen, ergibt sich für diese bekannte Einrichtung keine Anwendungsmöglichkeit. In der Praxis wird vielmehr bei größeren Maschinen von einem Prüfer die Bürstenkante visuell beobachtet und nach vorgegebenen, mehr oder weniger subjektiven Kriterien bewertet. Vorschläge aus der DE-OS 2 449 935, das vom Bürstenfeuer anstehende Licht mittels eines optischen Leiters zu übertragen und in ein elektrisches Signal zu wandeln, haben sich nicht bewährt.

Aus NTIS Tech Notes July 1988, Springfield, VA (US) ist weiterhin ein Verfahren zur Analyse des Motorstromes bekannt, bei dem der Motorstrom mit einem induktiven Stromwandler berührungslos erfaßt und einer Analyse unterzogen wird. Insbesondere aus dem Frequenzspektrum des Stroms sollen dabei mechanische Belastungen des Motors erkannt werden können.

Aufgabe der Erfindung ist es demgegenüber, Verfahren zur Bewertung von Lichtbögen an Gleitkontakten von elektrischen Maschinen vorzuschlagen und zugehörige Meßanordnungen zu schaffen, mit denen insbesondere das Bürstenfeuer von Motoren objektiv erfaßt werden kann. Diese Verfahren sollen im Rahmen einer automatischen Fertigungslinie einsetzbar sein.

Die Aufgabe ist erfindungsgemäß bei einem Verfahren der eingangs genannten Art dadurch gelöst, daß der Motorstrom gemessen und dessen vom Lichtbogen, insbesondere Bürstenfeuer erzeugte hochfrequente Anteil im Motorstrom an den Anschlußklemmen der elektrischen Maschine ausgekoppelt und kapazitiv kurzgeschlossen wird und daß dieser hochfrequente Anteil erfaßt und ausgewertet wird. Alternativ dazu wird die Aufgabe dadurch gelöst, daß die von den Anschlußklemmen gegen das Gehäuse abfließenden hochfrequenten Streuströme erfaßt und kapazitiv kurzgeschlossen werden und daß diese hochfrequenten Streuströme erfaßt und ausgewertet werden. Vorzugsweise werden dabei jeweils im Bereich von 1 MHz bis 20 MHz ausgewertet.

Eine erste erfindungsgemäße Meßanordnung zur Bürstenfeuerbewertung ist dadurch gekennzeichnet, daß zwischen die Anschlußleitungen ein Kondensator geeigneter Kapazität geschaltet wird, über den die hochfrequenten Stromanteile fließen, wobei dem Strompfad für die hochfrequenten Stromanteile der Stromwandler mit dem Auswertegerät zugeordnet ist. Alternativ dazu ist in entsprechender Auslegung zwischen einer der Anschlußklemmen und dem Gehäuse ein Kondensator geeigneter Kapazität geschaltet, über den hochfrequente Streuströme fließen, wobei dem Strompfad für die hochfrequenten Streuströme der Stromwandler mit dem Auswertegerät zugeordnet ist.

Insbesondere durch die Verwendung des Stromwandlers ist das erfindungsgemäße Verfahren und die zugehörige Meßanordnung leicht für die unterschiedlichsten Anwendungen adaptierbar. Ein Rüstaufwand bei Typwechsel ist nicht notwendig. Es sind wesentlich geringere Prüfzeiten als bisher notwendig, wobei das neue Verfahren unempfindlich gegen elektromagnetische Störungen ist. Nunmehr kann insbesondere das Bürstenfeuer auch unmittelbar unter den Bürsten erkannt werden, wobei sich eine Überwachung unabhängig von Form, Anzahl, Position und Größe speziell der Bürste bei der elektrischen Maschine ergibt. Insgesamt ist damit das vorgeschlagene Verfahren und die zugehörige Meßanordnung in hohem Maße automatisierungsfreundlich.

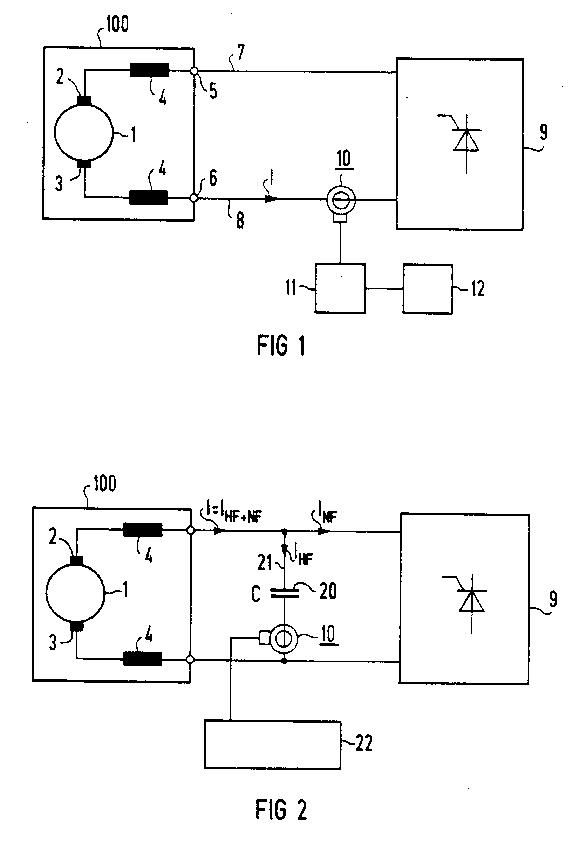

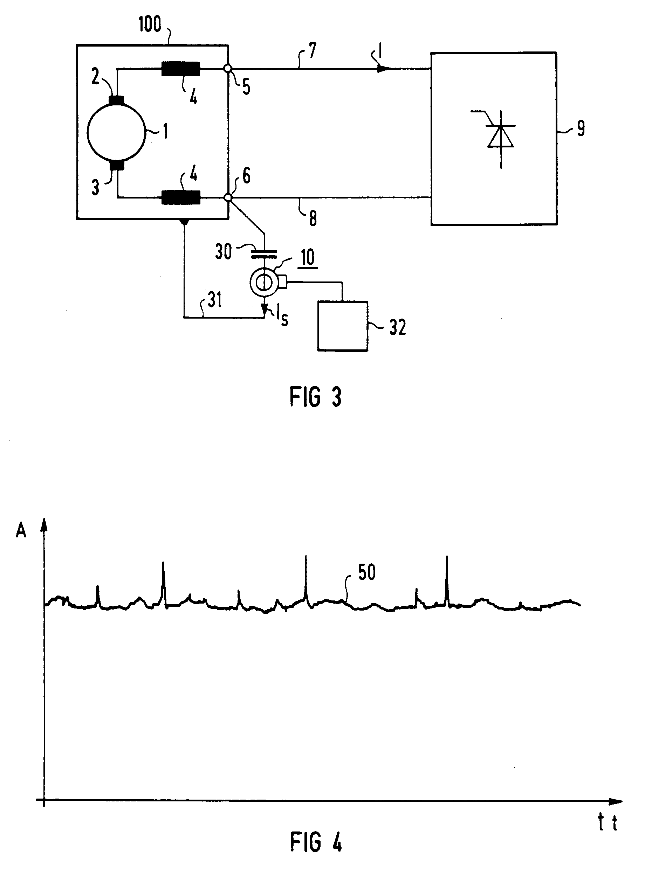

Weitere Einzelheiten und Vorteile der Erfindung ergeben sich aus der nachfolgenden Figurenbeschreibung von Ausführungsbeispielen anhand der Zeichnung. Es zeigen die Figuren 1, 2 und 3 jeweils als Meßschaltbild unterschiedliche Realisierungsmöglichkeiten der Erfindung und Figur 4 ein mit dem Meßaufbau gemäß einem der Figuren 1 bis 3 aufgenommenes Amplituden-Zeit-Diagramm.

Die Figuren werden teilweise zusammen beschrieben:

In den Figuren 1 bis 3 ist ein elektrischer Motor mit 1 bezeichnet, an den schematisch angedeutet jeweils zwei Bürsten 2 und 3 als Kommutatorelektroden angedeutet sind. Alternativ dazu können auch Gleitkontakte oder Schleifringe vorhanden sein.

Von den Kommutatorelektroden 2 und 3 kommen jeweils Leitungen über identische Spulen 4 als Wendepolwicklungen zu Anschlußklemmen 5 und 6 des Motorgehäuses, welches insgesamt als 100 bezeichnet wird. Von den Anschlußklemmen 5 und 6 gehen jeweils Leitungen 7 und 8 zu entsprechenden Einheiten zur Steuerung des Motors, beispielsweise einem Umrichter 9.

Soweit entspricht Figur 1 einem Motor mit üblichem Aufbau. Das bei Motorlauf zwangsläufig entstehende Bürstenfeuer wurde bisher visuell gemessen und vom Prüfer mit einer sogenannten Kommutierungsnote bewertet. Letztere Kommutierungsnote war dann Grundlage für die Qualitätskontrolle in der Fertigung.

Nunmehr wird ein HF-Stromwandler 10 verwendet, der als induktiver, ringförmiger Wandler ausgebildet ist und berührungslos über jede Leitung geschoben werden kann. Gemäß Figur 1 ist der HF-Stromwandler über eine der Anschlußleitungen 7 und 8 zur Messung des Motorstromes J geschoben. Dem Wandler 10 ist ein Bandpaß 11 nachgeschaltet, der auf die hochfrequenten Stromanteile ausgelegt ist, so daß auf dem Kanal 12 eines Sichtgerätes oder dergleichen der hochfrequente Stromanteil wiedergegeben ist.

In Figur 2 ist zwischen die beiden Anschlußleitungen 7 und 8 des Motors 1 über eine Verbindungsleitung 21 ein Kondensator 20 mit Kapazität C geschaltet. Wenn über die Anschlußleitungen 7 bzw. 8 ein Strom j_{HF+NF} fließt, so wird über die Verbindungsleitung 21 nur dessen hochfrequenter Anteil J_{HF} abgezweigt, während im Ausgangskreis der niederfrequente Anteil J_{NF} verbleibt. Um die Verbindungsleitung 21 wird der HF-Wandler 10 appliziert und das so für die hochfrequenten Anteile selektive Signal auf einem Kanal 22 eines Sichtgerätes oder dergleichen dargestellt.

In Figur 3 ist die Anschlußklemme 6 des Motors über einen Kondensator 30 und die Leitung 31 mit dem Gehäuse 100 verbunden. Um die Leitung 31 ist wiederum der HF-Stromwandler 10 appliziert, wobei dessen Signal auf den Kanal 32 eines Sichtgerätes oder dergleichen gegeben wird. Da das Gehäuse 100 üblicherweise geerdet ist, kann die Verbindung der Anschlußklemme 6 mit dem Gehäuse 100 auch über einen Erdschluß erfolgen. In beiden Fällen fließen über diesen Weg hochfrequente Streuströme J_{S}.

Insbesondere bei den Ausführungsbeispielen gemäß Figur 2 und 3 ist die Kapazität des Kondensators 20 bzw. 30 auf die spezielle elektrische Auslegung der gesamten Schaltung angepaßt. Sie kann üblicherweise im Bereich von einigen Mikrofarad (NF) liegen.

Als Anzeigegerät mit den Kanälen 12, 22 bzw. 32 kommt insbesondere ein Oszilloskop in Frage. Alternativ dazu können die Signale auch auf digital speichernde Meßgeräte, wie digitales Speicheroszilloskop oder Frequenz-Analysatoren, gegeben werden, um in einem Personalcomputer als Rechner weiterverarbeitet zu werden. Für den gleichen Zweck können auch andere Auswerteeinheiten, wie Grenzwertschalter oder analoge Signalspeicher, verwendet werden.

In Figur 4 bedeutet die Ordinate die Amplitude der mittels einer der Einrichtungen gemäß Figur 1 bis 3 aufgenommenen Signale als Funktion der Zeit. Es ist eine Signalkurve 50 wiedergegeben, welche in der Praxis an einem konkreten Beispiel gemessen wurde. Diese Signalkurve 50 wurde aus den hochfrequenten Signalanteilen des Motorstroms abgeleitet und zeigt periodische Peaks, die Ersatzkriterium für das Bürstenfeuer sind. Durch entsprechende Eichung kann unmittelbar bei Überschreiten von vorgegebenen Amplituden der Peaks ein Fehlersignal gegeben werden.

Im Vergleich zu der bisher in der Praxis häufig durchgeführten visuellen Beurteilungsmethode des Bürstenfeuers ergeben sich mit dem beschriebenen Verfahren und den einzelnen Meßanordnungen erhebliche Verbesserungen. Besonders vorteilhaft ist, daß auch nunmehr visuell gar nicht sichtbares Bürstenfeuer unterhalb der Kohle oder im geschlossenen Gehäuse des Motors erfaßt werden kann.

## Patentansprüche

1. Verfahren zur Bewertung von Lichtbögen an Gleitkontakten von elektrischen Maschinen, insbesondere des Bürstenfeuers bei Motoren od. dgl., bei dem ein Ersatzkriterium für den Lichtbogen, insbesondere das Bürstenfeuer, an den Anschlußklemmen der elektrischen Maschine erfaßt und hinsichtlich vorgegebener Kenngrößen ausgewertet wird,
**dadurch gekennzeichnet,** daß der vom Lichtbogen, insbesondere Bürstenfeuer, erzeugte hochfrequente Anteil (J_{HF}) im Motorstrom an den Anschlußklemmen der elektrischen Maschine ausgekoppelt und kapazitiv kurzgeschlossen wird und daß dieser hochfrequente Anteil erfaßt und ausgewertet wird.

2. Verfahren zur Bewertung von Lichtbögen an Gleitkontakten von elektrischen Maschinen, insbesondere des Bürstenfeuers bei Motoren od. dgl., bei dem ein Ersatzkriterium für den Lichtbogen, insbesondere das Bürstenfeuer, an den Anschlußklemmen der elektrischen Maschine erfaßt und hinsichtlich vorgegebener Kenngrößen ausgewertet wird, **dadurch gekennzeichnet,** daß die von den Anschlußklemmen der elektrischen Maschine gegen dessen Gehäuse abfließenden hochfrequenten Streuströme (J_{S}) ausgekoppelt und kapazitiv kurzgeschlossen werden und daß die hochfrequenten Streuströme erfaßt und ausgewertet werden.

3. Verfahren nach Anspruch 1 oder Anspruch 2, **dadurch gekennzeichnet,** daß hochfrequente Stromanteile bzw. Streuströme im Bereich von 1 MHz bis 20 MHz ausgewertet werden.

4. Verfahren nach Anspruch 1 oder Anspruch 2, **dadurch gekennzeichnet,** daß die hochfrequenten Stromanteile bzw. Streuströme mittels eines HF-Stromwandlers (10) gemessen werden.

5. Meßanordnung zur Lichtbogen-, insbesondere Bürstenfeuerbewertung gemäß einem Verfahren nach Anspruch 1, wobei die Anschlußklemmen der elektrischen Maschine über Ausgangsleitungen mit Einheiten zur elektrischen Versorgung und/oder Steuerung verbunden sind und wobei ein HF-Stromwandler (10) und ein zugehöriges Auswertegerät (22) vorhanden sind, **dadurch gekennzeichnet,** daß zwischen die Ausgangsleitungen (7, 8) ein Kondensator (20) geeigneter Kapazität (C) geschaltet ist, über den die hochfrequenten Stromanteile (J_{HF}) fließen, wobei dem Strompfad (21) für die hochfrequenten Stromanteile (I_{KF}) der Stromwandler (10) mit dem Auswertegerät (22) zugeordnet ist.

6. Meßanordnung zur Lichtbogen-, insbesondere Bürstenfeuerbewertung gemäß einem Verfahren nach Anspruch 2, wobei die Anschlußklemmen der elektrischen Maschine über Ausgangsleitungen mit Einheiten zur elektrischen Versorgung und/oder Steuerung verbunden sind und wobei ein HF-Stromwandler (10) und ein zugehöriges Auswertegerät (32) vorhanden sind, **dadurch gekennzeichnet,** daß zwischen einer der Anschlußklemmen (5 oder 6) und Gehäuse (100) ein Kondensator (30) geeigneter Kapazität (C) geschaltet ist, über den hochfrequente Streuströme (J_{S}) abfließen, wobei dem Strompfad (31) für die hochfrequenten Streuströme (J_{S}) der Stromwandler (10) mit dem Auswertegerät (32) zugeordnet ist.

7. Meßanordnung nach Anspruch 5 oder Anspruch 6, **dadurch gekennzeichnet,** daß das Auswertegerät (22, 32) ein Oszilloskop ist.

8. Meßanordnung nach Anspruch 5 oder Anspruch 6, **dadurch gekennzeichnet,** daß das Auswertegerät (22, 32) ein Spektrum-Analysator ist.

9. Meßanordnung nach Anspruch 5 oder Anspruch 6, **dadurch gekennzeichnet,** daß das Auswertegerät (22, 32) eine Schaltung zur Erfassung hochfrequenter Signale ist.

## Claims

1. Method for assessment of arcs on sliding contacts of electrical machines, especially of the brush sparking in motors or the like, in which an equivalent criterion for the arc, especially the brush sparking, is detected on the connecting terminals of the electrical machine and is evaluated in terms of predetermined characteristic variables, characterized in that the radio-frequency element (J_{HF}), which is produced by the arc, especially brush sparking, in the motor current is extracted at the connecting terminals of the electrical machine and is capacitively short-circuited, and in that this radio-frequency element is detected and evaluated.

2. Method for assessment of arcs on sliding contacts of electrical machines, especially of the brush sparking in motors or the like, in which an equivalent criterion for the arc, especially the brush sparking, is detected on the connecting terminals of the electrical machine and is evaluated in terms of predetermined characteristic variables, characterized in that the radio-frequency stray currents (J_{S}) flowing out from the connecting terminals of the electrical machine to its housing are extracted and capacitively short-circuited, and in that the radio-frequency stray currents are detected and evaluated.

3. Method according to Claim 1 or Claim 2, characterized in that radio-frequency current elements or stray currents are evaluated in the band from 1 MHz to 20 MHz.

4. Method according to Claim 1 or Claim 2, characterized in that radio-frequency current elements and stray currents are measured by means of an RF current transformer (10).

5. Measurement arrangement for arc assessment, especially brush sparking assessment, in accordance with a method according to Claim 1, the connecting terminals of the electrical machine being connected via output lines to units for electrical supply and/or control, and an RF current transformer (10) and an associated evaluation apparatus (22) being provided, characterized in that a capacitor (20) of suitable capacitance (C) is connected between the output lines (7, 8), via which capacitor (20) the radio-frequency current elements (J_{HF}) flow, the current transformer (10) with the evaluation apparatus (22) being assigned to the current path (21) for the radio-frequency current elements (I_{KF}).

6. Measurement arrangement for arc assessment, especially brush sparking assessment, in accordance with a method according to Claim 2, the connecting terminals of the electrical machine being connected via output lines to units for electrical supply and/or control, and an RF current transformer (10) and an associated evaluation apparatus (32) being provided, characterized in that a capacitor (30) of suitable capacitance (C) is connected between one of the connecting terminals (5 or 6) and the housing (100), via which capacitor (30) radio-frequency stray currents (J_{S}) flow, the current transformer (10) with the evaluation apparatus (32) being assigned to the current path (31) for the radio-frequency stray currents (J_{S}).

7. Measurement arrangement according to Claim 5 or Claim 6, characterized in that the evaluation apparatus (22, 32) is an oscilloscope.

8. Measurement arrangement according to Claim 5 or Claim 6, characterized in that the evaluation apparatus (22, 32) is a spectrum analyser.

9. Measurement arrangement according to Claim 5 or Claim 6, characterized in that the evaluation apparatus (22, 32) is a circuit for detecting radio-frequency signals.

## Revendications

1. Procédé pour évaluer des arcs électriques au niveau de contacts glissants de machines électriques, notamment du crachement au niveau des balais dans des moteurs ou analogues, selon lequel un critère de remplacement pour les arcs électriques, notamment le crachement au niveau des balais, est détecté sur les bornes de raccordement de la machine électrique et est évalué en rapport avec des grandeurs caractéristiques prédéterminées, caractérisé par le fait que la composante haute fréquence (J_{HF}) produite par l'arc électrique, notamment le crachement au niveau des balais, et présente dans le courant du moteur est découplée au niveau des bornes de raccordement de la machine électrique et est court-circuitée de façon capacitive et que cette composante à haute fréquence est détectée et évaluée.

2. Procédé pour évaluer des arcs électriques au niveau de contacts glissants de machines électriques, notamment du crachement au niveau des balais dans des moteurs ou analogues, selon lequel un critère de remplacement pour les arcs électriques, notamment le crachement au niveau des balais, est détecté sur les bornes de raccordement de la machine électrique et est évalué en rapport avec des grandeurs caractéristiques prédéterminées, caractérisé par le fait que des courants de fuite haute fréquence (J_{S}), qui partent des bornes de raccordement de la machine électrique en direction de la carcasse de cette dernière, sont découplées et court-circuitées de façon capacitive et que les courants de fuite haute fréquence sont détectés et évalués.

3. Procédé suivant la revendication 1 ou 2, caractérisé par le fait qu'on évalue des composantes de courant à haute fréquence et des courants de fuite haute fréquence dans la gamme de 1 MHz à 20 MHz.

4. Procédé suivant la revendication 1 ou 2, caractérisé par le fait qu'on mesure les composantes de courant ou les courants de fuite haute fréquence au moyen d'un transformateur d'intensité HF (10).

5. Dispositif de mesure pour l'évaluation d'arcs électriques, et notamment de crachements au niveau des balais conformément à un procédé selon la revendication 1, dans lequel les bornes de raccordement de la machine électrique sont reliées, par l'intermédiaire des conducteurs de sortie, à des unités d'alimentation électrique et/ou de commande et dans lequel sont prévus un transformateur d'intensité HF (10) et un appareil associé d'évaluation (22), caractérisé par le fait qu'entre les conducteurs de sortie (7,8) est branché un condensateur (20) possédant une capacité appropriée (C) et par l'intermédiaire duquel circulent les composantes haute fréquence du courant (J_{HF}), le transformateur d'intensité (10) équipé de l'appareil d'évaluation (22) étant associé à la voie de courant (21) pour les composantes haute fréquence de la tension (I_{KF}).

6. Dispositif de mesure pour l'évaluation d'arcs électriques, et notamment de crachements au niveau des balais conformément à un procédé selon la revendication 2, dans lequel les bornes de raccordement de la machine électrique sont reliées, par l'intermédiaire des conducteurs de sortie, à des unités d'alimentation électrique et/ou de commande et dans lequel sont prévus un transformateur d'intensité HF (10) et un appareil d'évaluation associé (22), caractérisé par le fait qu'entre l'une des bornes de raccordement (5 ou 6) et la carcasse (100) est branché un condensateur (30) possédant une capacité (C) appropriée, par l'intermédiaire duquel s'évacuent des courants de fuite (J_{S}) haute fréquence, le transformateur d'intensité (10) équipé de l'appareil d'évaluation (32) étant associé à la voie de courant (31) pour le courant de fuite (J_{S}) haute fréquence.

7. Dispositif de mesure suivant la revendication 5 ou 6, caractérisé par le fait que l'appareil d'évaluation (22, 32) est un oscilloscope.

8. Dispositif de mesure suivant la revendication 5 ou 6, caractérisé par le fait que l'appareil d'évaluation (22,32) est un analyseur de spectre.

9. Dispositif de mesure suivant la revendication 5 ou 6, caractérisé par le fait que l'appareil d'évaluation (22,32) est un circuit servant à détecter des signaux haute fréquence.
